(19) Europäisches Patentamt
European Patent Office
Office européen des brevets

(11) **EP 2 752 675 B1**

(12) **EUROPEAN PATENT SPECIFICATION**

(45) Date of publication and mention
of the grant of the patent:
**05.08.2020 Bulletin 2020/32**

(21) Application number: **12826813.3**

(22) Date of filing: **27.08.2012**

(51) Int Cl.:
*G01R 33/09* [(2006.01)]          *H01L 43/08* [(2006.01)]
*H01L 43/12* [(2006.01)]          *G01R 33/02* [(2006.01)]

(86) International application number:
**PCT/CN2012/080607**

(87) International publication number:
**WO 2013/029512 (07.03.2013 Gazette 2013/10)**

(54) **MTJ THREE-AXIS MAGNETIC FIELD SENSOR AND ENCAPSULATION METHOD THEREOF**

DREIACHSIGER MTJ-MAGNETFELDSENSOR UND VERKAPSELUNGSVERFAHREN DAFÜR

CAPTEUR DE CHAMP MAGNÉTIQUE À AXE TRIPLE MTJ ET SON PROCÉDÉ D'ENCAPSULATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **30.08.2011 CN 201110251904**

(43) Date of publication of application:
**09.07.2014 Bulletin 2014/28**

(73) Proprietor: **Multidimension Technology Co., Ltd.
Free Trade Zone
Zhangjiagang,
Jiangsu 215634 (CN)**

(72) Inventors:
• **LEI, Xiaofeng
Zhangjiagang
Jiangsu 215600 (CN)**
• **ZHANG, Xiaojun
Zhangjiagang
Jiangsu 215600 (CN)**
• **LI, Wei
Zhangjiagang
Jiangsu 215600 (CN)**
• **XUE, Songsheng
Zhangjiagang
Jiangsu 215600 (CN)**

(74) Representative: **HGF
1 City Walk
Leeds LS11 9DX (GB)**

(56) References cited:
EP-A1- 1 860 451          EP-A2- 1 580 568
WO-A1-2006/070305          WO-A1-2009/119346
WO-A1-2009/137802          WO-A1-2011/092406
CN-A- 101 203 769          CN-A- 101 290 343
CN-A- 101 325 210          CN-A- 101 813 479
CN-A- 102 385 043          CN-A- 102 426 344
CN-U- 202 210 145          CN-U- 202 362 441
JP-A- 2004 006 752          JP-A- 2004 128 474
JP-A- 2009 122 049          JP-A- 2009 216 390
US-A1- 2005 270 020          US-A1- 2006 087 006
US-A1- 2009 045 809          US-A1- 2009 237 074
US-A1- 2009 315 129          US-A1- 2010 252 939

**Description**

**TECHNICAL FIELD**

The present invention relates to the design of a magnetic field sensor, in particular triaxial magnetic field sensor.

**BACKGROUND ART**

In recent years Magnetic Tunnel Junctions (MTJ) have begun finding acceptance in industrial applications as a new type of magnetoresistive sensor, using the Tunneling Magnetoresistance (TMR) Effect of magnetic multilayer materials. In this effect the magnitude and direction of a magnetic field applied to the multilayered film changes of the resistance of the multilayer film. The TMR effect is larger than the AMR (Anisotropic Magnetic Resistance) effect, and it also known to have better temperature stability than the Hall Effect. As a result, TMR magnetic field sensors have the advantages of higher sensitivity, lower power consumption, better linearity, wider dynamic range, better temperature characteristics, and lower noise than AMR, GMR, or Hall devices. Moreover, MTJs can be easily fabricated with existing chip manufacturing technology which facilitates the production of very small integrated magnetic field sensors.
Multi-axis magnetic field sensors generally have more than a single sensor chip integrated in the package, in order to provide vector measurement capability with good orthogonality. Because the magnetic field is a vector field, a multi-axis magnetic field sensor has a very wide range of applications, especially for electronic compass, which use biaxial or triaxial sensors for geomagnetic field measurements. As a result of this common application, simplified means of production of highly-integrated single-chip multi-axis magnetic field sensors are strongly desired.
When deposited on the same wafer, GMR and MTJ materials used for the different sensor axes have the same magnetic moments, and after annealing have the same pinned layer direction, which makes fabrication of single-chip three-axis sensors difficult. As such, the most common approach to manufacture a GMR triaxial sensor is to package an X-axis sensor, a Y-axis sensor, and a Z-axis sensor deposited on three different substrates; such a GMR triaxial sensor suffers limitations such as excessive size, high packaging cost, and it has a lower sensitivity and higher power consumption than a MTJ sensor.
As can be seen from the above, current AMR, Hall, and GMR triaxial sensors are disadvantageous in that they have excessive size, high packaging cost, lower sensitivity, higher power consumption, and the manufacturing methods are impractical.

**SUMMARY OF THE INVENTION**

Seeking to resolve the above problems, the present invention provides a compact triaxial sensor with higher sensitivity and lower power consumption. In accordance with the appended claims, there is provided a triaxial MTJ sensor and a method of packaging a triaxial MTJ sensor.
There is provided a triaxial MTJ sensor, comprising:

an X-axis bridge sensor (25) with a sensing direction along a X-axis,

a Y-axis bridge sensor (26) that has a sensing direction along a Y-axis,

a Z-axis sensor (27) that has a sensing direction along a Z-axis, and

an ASIC chip (19) for signal conditioning,

wherein the X-axis, the Y-axis, and the Z-axis are mutually orthogonal;
characterized in that the X-axis bridge sensor, the Y-axis bridge sensor, and the Z-axis sensor are connected onto a connection face of the ASIC chip;
wherein said Z-axis sensor comprises a plurality of electrically interconnected magnetic sensor chips (24), and each of the magnetic sensor chips is comprised of a substrate with a deposition face onto which a MTJ element is deposited and an attachment face that is acutely or obtusely angled with respect to the deposition face, and wherein an attachment face of each magnetic sensor chip is connected onto the connection face of the ASIC chip.
Each of the Z-axis magnetic sensor chips may comprise a pair of parallel attachment faces.
Each of the Z-axis magnetic sensor chips may comprise a pair of attachment faces that are symmetrically arranged with respect to a plane perpendicular to the deposition face.
Preferably, the X-axis bridge sensor is a MTJ sensor.
Preferably, wherein the Y-axis bridge sensor is a MTJ sensor.

Preferably, the X-axis bridge sensor and the Y-axis bridge sensor are connected with the ASIC chip using gold wire bonds.

Preferably, the X-axis bridge sensor and the Y-axis bridge sensor are connected with the ASIC chip using a solder bump.

Preferably, the X-axis bridge sensor and the Y-axis bridge sensor are integrated into the same chip.

The X-axis bridge sensor may have two branches electrically connected in parallel that comprise a first pair of MTJ elements and a second pair of MTJ elements that are each separately electrically connected between the MTJ elements of the first pair,

wherein the MTJ elements of the second pair have a lower magnetoresistive sensitivity than the MTJ elements of the first pair, and

the Y-axis bridge sensor having two branches electrically connected in parallel that comprise a third pair of MTJ elements and a fourth pair of MTJ elements that are each separately electrically connected between the MTJ elements of the third pair,

each MTJ element of the Y-axis bridge sensor has a pinned layer with a common pinned layer magnetization direction and a free layer with a respective freelayer magnetization direction,

wherein in the absence of an magnetic field external to the triaxial MTJ sensor,

the freelayer magnetization directions of each MTJ element of the third pair deviates from the pinned layer magnetization direction by an angle, and

the freelayer magnetization directions of each MTJ element of the fourth pair deviates from the pinned layer magnetization direction by an angle of opposite sign and equal magnitude to the MTJ elements of the third pair.

Preferably, each of the sensing chips is connected with the ASIC chip using solder bumps.

Preferably, the Z-axis sensor includes two or four MTJ magnetic sensor chips, and said MTJ sensor chips are symmetrically arranged on the ASIC chip.

A triaxial MTJ sensor packaging method, comprising the steps of

A) fabricating a X-axis bridge sensor that has a sensing direction along a X-axis and electrically connecting the X-axis sensor with an ASIC chip,

B) fabricating a Y-axis bridge sensor that has a sensing direction along a Y-axis and electrically connecting the Y-axis sensor with the ASIC chip,

C) fabricating MTJ magnetoresistive elements on the deposition face of a wafer, cutting said MTJ wafer obliquely to form MTJ magnetic sensor chips with attachment faces that are acutely or obtusely angled with respect to the deposition face; placing one of the attachment faces of each MTJ magnetic sensor chip onto the ASIC chip; physically connecting each of the MTJ magnetic sensor chips with the ASIC chip using solder bumps; and electrically connecting the MTJ magnetic sensing elements to form a Z-axis magnetic sensor.

A MTJ three-axis sensor packaging method, comprising the steps of

A) fabricating a X-axis magnetic field sensor bridge that has a sensing direction along a X-axis and electrically connecting the X-axis sensor to an ASIC chip,

B) fabricating a Y-axis magnetic field sensor bridge that has a sensing direction along a Y-axis and electrically connecting the Y-axis sensor to the ASIC chip,

C) fabricating MTJ magnetoresistive elements on the deposition face of a wafer, etching the opposite side of said wafer to form slopes; cutting the wafer to form MTJ magnetic sensor chips with attachment faces that are acutely or obtusely angled with respect to the deposition face; placing one of the attachment faces of each MTJ magnetic sensor chip onto the ASIC chip; physically connecting each of the MTJ magnetic sensor chips with the ASIC chip using solder bumps; and electrically connecting the MTJ magnetic sensing elements to form a Z-axis magnetic sensor.

In order to solve the above technical problem, the technical solution adopted in the present invention uses the above structure, to achieve a high level of integration, high sensitivity, low power consumption, good linearity, wide dynamic range, good temperature performance, and low noise performance.

**BRIEF DESCRIPTION OF THE DRAWINGS**

Figure 1 is a schematic drawing of the magnetic resistance of a magnetic tunnel junction element.

Figure 2 is a graph of the ideal output of an MTJ element.

Figure 3 is a schematic diagram of MTJ elements electrically connected in series.

Figure 4 is a schematic diagram of a MTJ push-pull bridge sensor.

Figure 5 is a plot of the analog output of a MTJ push-pull bridge sensor.

Figure 6 is a schematic diagram of a MTJ referenced bridge sensor.

Figure 7 is simulation plot of the output of a MTJ referenced bridge sensor.

Figure 8 is a schematic view of a type of single-chip biaxial magnetic field sensor.

Figure 9 is a cross-sectional view of the first step of the Z-axis magnetic field sensor chip preparation method.

Figure 10 is a view of the second step of the Z-axis magnetic field sensor chip preparation method

Figure 11 is a view of the third step of the Z-axis magnetic field sensor chip preparation method

Figure 12 is a view of the fourth step of the Z-axis magnetic field sensor chip preparation method

Figure 13 is a cross-sectional view of the first step of the Z-axis magnetic field sensor chip second preparation method.

Figure 14 is a view of the second step of the Z-axis magnetic field sensor chip second preparation method

Figure 15 is a view of the third step of the Z-axis magnetic field sensor chip second preparation method

Figure 16 is a view of the fourth step of the Z-axis magnetic field sensor chip second preparation method

Figure 17 is a schematic view of the structure of the triaxial magnetic field sensor prepared using the first preparation method.

Figure 18 is a schematic view of the structure of the triaxial magnetic field sensor prepared using the second preparation method.

In the drawings: 1 is a MTJ element; 2 is a magnetic pinned layer; 3 is an antiferromagnetic layer; 4 is a ferromagnetic layer; 5 is a tunnel barrier layer; 6 is a ferromagnetic free layer; 7 is the ferromagnetic free layer magnetization direction; 8 is the ferromagnetic pinned layer magnetization direction; 9 is an applied magnetic field; 10 is the sensing direction; 11 is a seed layer; 12 is an upper electrode; 13 is the resistance of an MTJ element; 14 is the low resistance value of an MTJ element; 15 is the high resistance value of an MTJ element; 16 is electric current; 17 is a permanent magnet; 18 is a substrate; 19 is an ASIC chip; 20 is solder bump; 21 is an attachment edge; 22 is a chip surface; 23 is attachment angle; 24 is the MTJ magnetic sensor chip ; 25 is an X-axis bridge sensor; 26 is a Y-axis bridge sensor; 27 is a Z-axis bridge sensor; 41 is the direction of the magnetization of the free layer R1; 42 is the direction of the magnetization of the free layer R2; 43 is the direction of the magnetization of the free layer R3; and 44 is the direction of the magnetization of the free layer R4.

## DESCRIPTION OF THE PREFERRED EMBODIMENTS

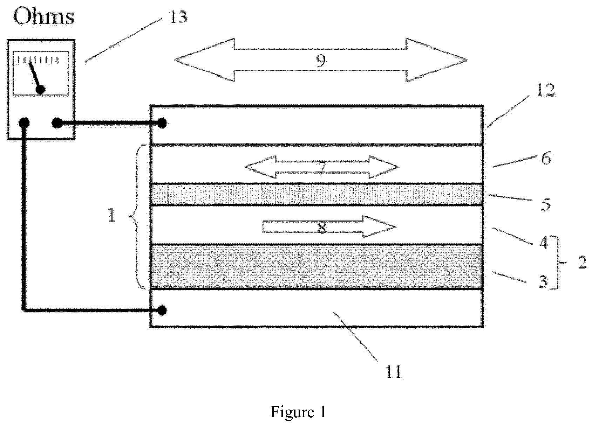

Below in conjunction with the accompanying drawings (Figures 1-18) preferred embodiments of the present invention are elaborated, such that the advantages and features of the present invention are more easily understood by those skilled in the art, so that the scope of protection of the present invention is clearly defined.

Tunnel junction magnetoresistance overview:

Figure 1 is a schematic view of a standard MTJ element. The standard MTJ element 1 includes a free ferromagnetic layer 6, a ferromagnetic pinned layer 2, and a tunnel barrier layer 5 between the ferromagnetic layers. The free ferromagnetic layer 6 is composed of a ferromagnetic material, and the magnetization direction of the ferromagnetic free layer is able to change in response to an external magnetic field. The ferromagnetic pinning layer 2 has a magnetization direction that is pinned in one direction, and it does not change under general operating conditions. A ferromagnetic pinned layer 4 may be either at the top or bottom of the antiferromagnetic layer 3. The MTJ structure is usually deposited on top of a conductive seed layer 11, while an electrode 12 is usually deposited on top of the MTJ structure. The resistance of the MTJ element is measured between the seed layer 11 and the upper electrode layer 12, and its value 13 is representative of the relative orientation of the magnetizations of the ferromagnetic free layer 6 and the ferromagnetic pinned layer 2.

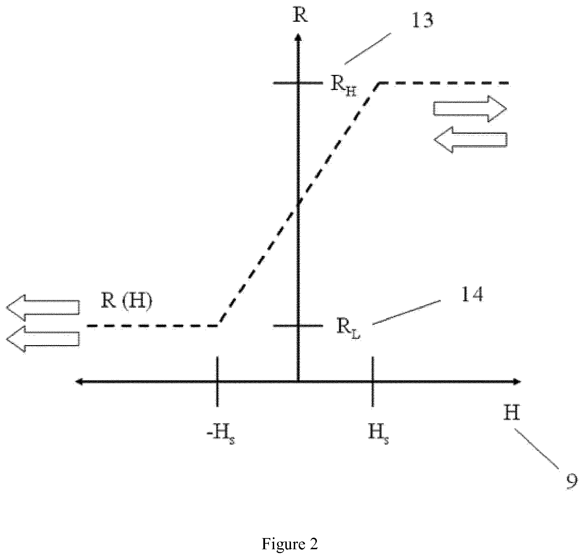

Figure 2 is an ideal output response curve of an MTJ element, the output curve in the low-resistance state $R_L$ 14 and the high-impedance state $R_H$ 15, represent the low-resistance state 14 and the high-resistance state 15 of the saturated MTJ. When the magnetic free layer 7 magnetization direction and magnetic pinning layer 8 direction of magnetization are parallel, the measured resistance value 13 of the MTJ is the low-resistance state; when the magnetization direction of the ferromagnetic free layer 7 and the magnetization direction of the ferromagnetic pinned layer 8 are anti-parallel, the resistance value of the MTJ element 13 is the high-resistance value 15. By known techniques, the resistance of the MTJ element 1 is made linear as a function of applied magnetic field in the magnetic field range between the high-resistance state and the low resistance state, the saturation fields $-H_s$ and $H_s$ then define the linear range of the MTJ element.

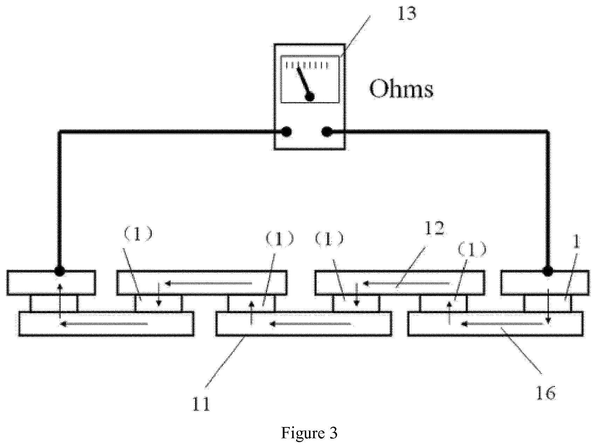

Figure 3 is a schematic view of several MTJs connected in series to form a magnetoresistive element. A string of connected MTJs 1 can reduce noise and improve the stability of the sensor. In MTJ magnetoresistive element 24, the bias voltage of each MTJ 1 is decreased proportionally to the number of MTJs in the string. This reduces the current required to generate a large voltage output, thereby reducing the shot noise, and it also improves the ESD tolerance of the sensor. In addition to improving the output signal and increasing ESD tolerance, increasing the number of MTJs improves noise performance because uncorrelated random behavior of each individual MTJ element is averaged out.

Push-pull bridge sensor design:

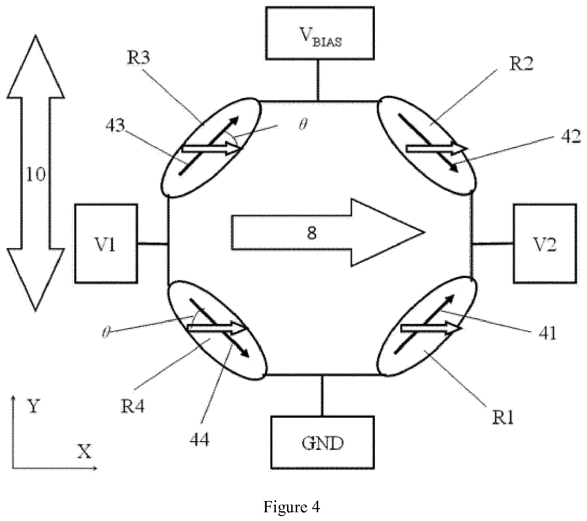

Figure 4 is a schematic diagram of a MTJ push-pull full-bridge sensor. The four MTJ elements R1, R2, R3, and R4 are interconnected as a full-bridge, and each MTJ element is composed of one or a plurality of MTJs 1 connected in series (Figure 2). For each of the magnetoresistive elements the magnetization direction of the pinned layer is the same, and the freelayer magnetization direction with respect to the pinned layer magnetization direction at is at an angle 9 (between 30° to 90°), and this angle θ is the same magnitude. Magnetoresistive element pairs (R1 and R3, R2 and R4) have the same free layer magnetization direction (41 and 43, 42 and 44), while magnetoresistive elements located adjacent to each other (R1 and R2, R3 and R4) have freelayer magnetization aligned in different directions (41and 42, 43 and 44). In this specific full-bridge configuration, the sensitive direction 10 is perpendicular to the ferromagnetic pinned layer's magnetization direction 8. Because the magnetization direction of the magnetic pinned layer 8 of each of the magnetoresistive elements is the same, this push-pull full bridge sensor design can be implemented on a single chip to form a push-pull full bridge sensor, without the use of a multi-chip packaging process or the need to perform local laser heating.

When a magnetic field is applied along the sensitive direction 10, it changes the relative orientation of the freelayer magnetization relative to the pinned layer magnetization. Therefore, magnetoresistive elements such that R1 and R3 show a resistance increase while the other two magnetoresistive elements R2 and R4 show a decreasing resistance. When the magnetic field is applied in the opposite direction then R1 and R3 resistance will be reduced while R2 and R4 resistance will be increased. The use of a combination of two pairs of magnetoresistive elements that have opposite response to the applied field, that is, a pair of MTJ elements has a resistance that increases while the other has a resistance that decreases, effectively doubling the response of the bridge circuit, produces what is called a "push-pull" bridge. In the ideal case, if the resistance value of resistor R1= (R1 + ΔR), R3 = (R1 + ΔR), R2 = (R2 - ΔR), and R4 = (R2 - ΔR), the bridge output becomes:

$$V1 - V2 = \frac{R2 - \Delta R - (R1 + \Delta R)}{R2 + R1} V_{bias} \tag{1}$$

Ideally, when R1 = R2> ΔR, the equation can be simplified:

$$V1 - V2 \approx \frac{-2\Delta R}{R2 + R1} V_{bias} \tag{2}$$

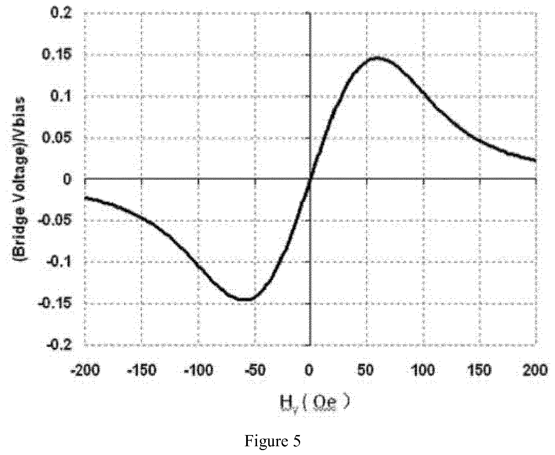

The simulated response for this push-pull bridge circuit is shown in Figure 5.

The required magnetization angle between the ferromagnetic free layer and the ferromagnetic pinned layer may be achieved in the following ways:

(1) Shape Anisotropy: Use shape anisotropy of the MTJ element to create easy magnetization axes, in order to bias the magnetic free layer magnetization directions. Shape anisotropy of the of the MTJ element can be adjusted by changing the length relative to the width of the MTJ element, and also by rotating the elements;

(2) Permanent Magnet Bias: Set permanent magnets around the MTJ element to produce a field to bias the free layer magnetization direction;

(3) Coil Bias: Deposit metal wires used to carry a current for generating a magnetic field in layers above or below the MTJ elements, in order to produce a field to bias magnetic free layer directions;

(4) Neel Coupling: Use the Neel Coupling field between the ferromagnetic pinned layer and the ferromagnetic free layer to bias ferromagnetic free layer magnetization;

(5) Exchange Bias: In this technique, weak exchange coupling to an adjacent antiferromagnetic layer on the freelayer creates an effective bias field. The strength can be tuned by placing a Cu or Ta layer between the antiferromagnetic layer and the freelayer, which reduces the strength of exchange bias.

Referenced Full-Bridge Magnetic Sensor Design:

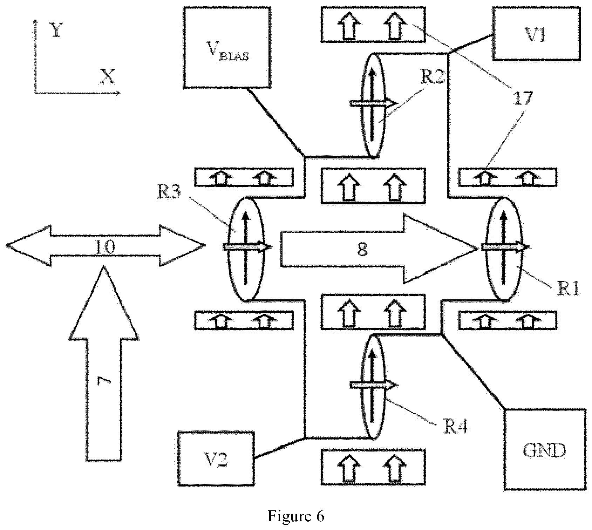

Figure 6 shows a schematic diagram of a referenced full bridge MTJ sensor. Here, four MTJ magnetoresistive elements R1, R2, R3 and R4 are interconnected to form a bridge, and each magnetoresistive element is composed of one or more MTJs connected in series (Figure 2). In this design, the output curve of magnetoresistive elements R1 and R3 is strongly dependent on the applied magnetic field 9, and these elements are referred to as the sensing arms. The magnetoresistive response of elements R2 and R4, on the other hand, is only weakly dependent on the applied magnetic field 9, and these elements are called the reference arms. The sensitive direction 10 of this referenced full-bridge structure is parallel to the pinning direction 8. This specific referenced bridge design utilizes the same ferromagnetic pinned layer direction for all bridge arms, and it can thus be built on the same chip as the push-pull full bridge sensor, without the use of a multi-chip packaging process or local laser heating.

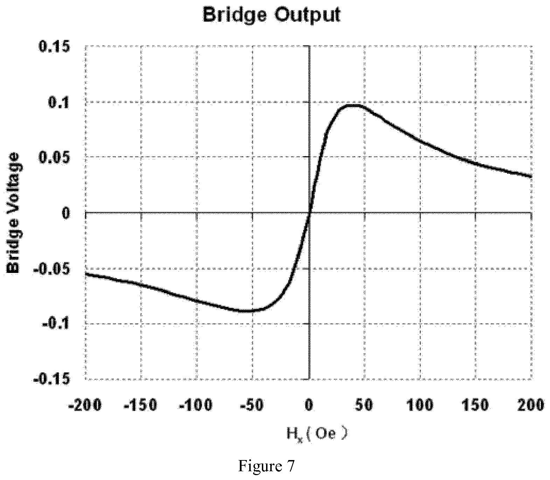

When a field is applied to the referenced full bridge sensor, the magnetic field component along the sensitive direction causes the sensor arms R1 and R3 to increase or decrease in resistance, while the reference arm elements R2 and R4 do not change much. In practice, the output of the referenced MTJ full-bridge sensor is linear over a wide field range. A simulation output response curve is shown in Figure 7.

In order to build a practical referenced bridge sensor, it is important to set different sensitivities for the sense and reference arms. The sensitivity of a magnetoresistive element is defined as the change in resistance as a function of applied magnetic field:

$$S_{MTJ} = \frac{1}{2}\left(\frac{R_H - R_L}{R_H + R_L}\right)\left(\frac{V_{bias}}{H_s}\right) \tag{3}$$

It is not practical to reduce the magnetoresistance of the reference arm with respect to the sensor arm, so the relative change in sensitivity between the reference and sense arms is best accomplished by changing $H_s$. This can be accomplished through any one of, or a combination of, the following methods:

(1) Magnetic Shielding: A high permeability ferromagnetic layer is deposited over the reference arm in order to attenuate the applied magnetic field;

(2) Shape Anisotropy: Pattern the reference and the sense elements into different sizes; therefore have different shape anisotropy energies and thus different sensitivities. It is most common to vary the length to width ratio of the sensing elements such that the demagnetizing field of the reference elements is much larger than the demagnetizing fields of the sensing elements ;

(3) Exchange Bias: This technique is used to create a bias field on the free layer of the MTJ element perpendicular to the sensitive direction of the MTJ element by using weak exchange coupling to an antiferromagnetic layer. A Cu or Ta barrier layer may be provided between the free layer and the exchange bias layer to reduce the strength of the exchange bias;

(4) In-Stack Bias: In this technique, permanent magnet alloys of Fe, Co, Cr or Pt are deposited onto the surface of the sensor element of the magnetic tunnel junction, and the resulting stray field biases the MTJ element 1. A large magnetic field can then be used to initialize the sensor at different angles. A very important advantage is that the bias field can eliminate the magnetic domains in the MTJ element to improve the stability and linearity of the MTJ element, and the direction of the magnetization can be adjusted to provide great flexibility in tuning the response.

Single-Chip Biaxial Magnetic Sensor Design:

Because the sensors are comprised of magnetoresistive films deposited simultaneously on the same wafer, the pinned layer magnetization directions of the areas used to make different sensor axes are the same. Unfortunately, the biaxial magnetic field sensors consist of two bridge sensors that must be rotated at a 90 ° angle with respect to each other. In the following we will describe the realization of the single chip biaxial magnetic field sensor. Single chip MTJ-axis magnetic field sensor design can be achieved through the following methods or combination of several methods:

Method 1: Local Laser Heating: After deposition the pinned layers of the different sensor bridges are aligned parallel to each other. A local laser pulse may be applied in the presence of a magnetic field to realign the pinned layer in specific areas;

Method 2: Multiple Depositions: Different magnetoresistive films may be deposited on different areas of the chip to achieve the correct pinned layer orientation for each sensor.

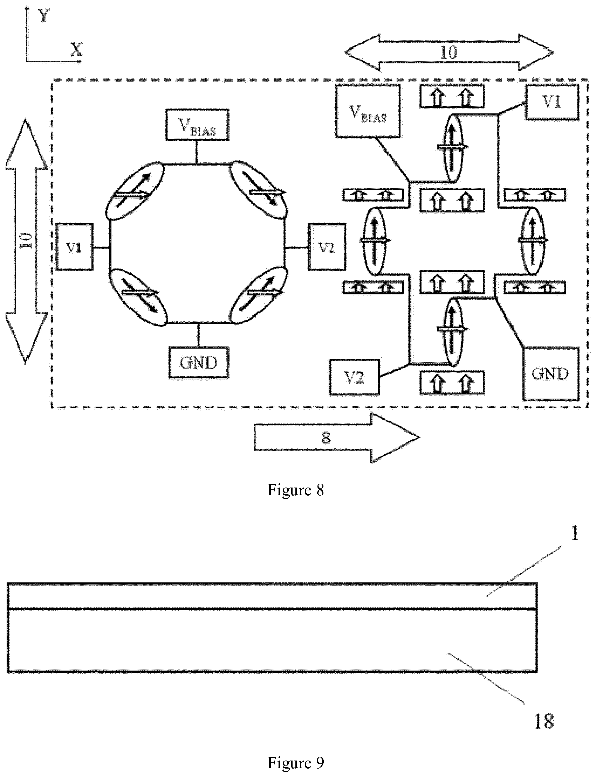

Method 3: Referenced/Push-Pull: A single chip MTJ biaxial magnetic field sensor may be achieved as shown on Figure 8. Full bridge and referenced bridge sensors can be developed that are sensitive to fields parallel or perpendicular to the pinned layer direction. These full-bridge sensors can be built on the same substrate using the same steps and the same ferromagnetic pinned layer 8 set direction.

Triaxial Magnetic Field Sensor Design:

A triaxial magnetic sensor comprising an X-axis bridge sensor 25 with a sensing direction along a X-axis, a Y-axis bridge sensor 26 that has a sensing direction along a Y-axis, a Z-axis sensor 27 that has a sensing direction along a Z-axis, wherein the X-axis, the Y-axis, and the Z-axis are mutually orthogonal; an ASIC chip 19 is connected with and matched to the X-axis 25, the Y-axis 26, and the Z-axis 27 sensor bridges; said Z-axis sensor 27 includes several interconnected magnetic sensor chips 24 and each of the interconnected magnetic sensor chips 24 is comprised of a substrate 18 onto which a MTJ element 1 is deposited, and each of the interconnected magnetic sensor chips 24 is positioned on the ASIC chip 19 along an attachment edge 21, said attachment edge 21 is adjacent to the surface edge 22, and it is oriented at an angle 23 with respect to the MTJ element edge 22, wherein said angle 23 is an acute angle or an obtuse angle. The ASIC chip 19 is used for signal conditioning.

The X-axis bridge sensor 25 and the Y-axis bridge sensor 26 are integrated into the same chip. Said X-axis bridge sensor 25 is a MTJ sensor. Said Y-axis bridge sensor 26 is a MTJ sensor. Said X-axis bridge sensor 25 is a referenced bridge sensor and the Y-axis bridge sensor 26 is a push-pull bridge sensor.

Said magnetic sensor chip 24 through the solder balls 20 and the ASIC chip 19 are electrically interconnected.

The Z-axis sensor 27 includes two or four MTJ magnetic sensor chips 24, said MTJ sensor chips 24are symmetrically arranged on the ASIC chip 19.

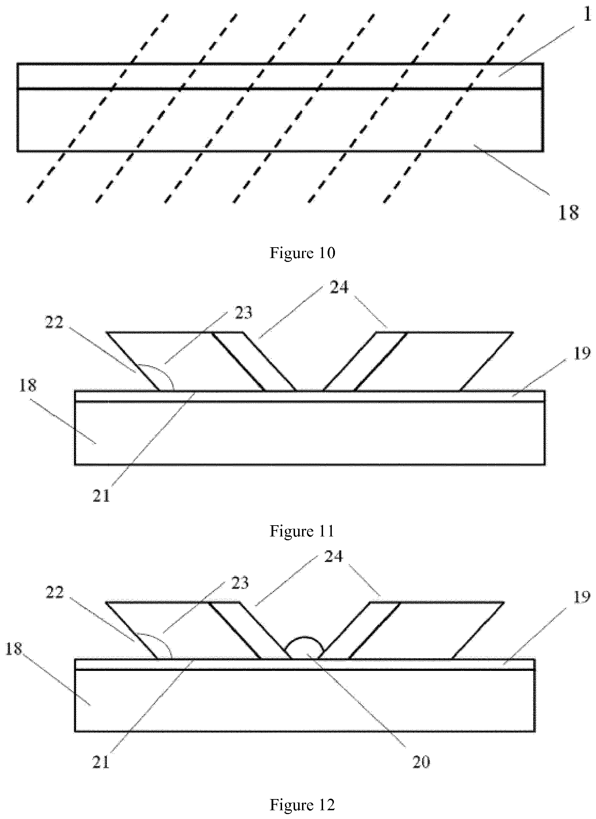

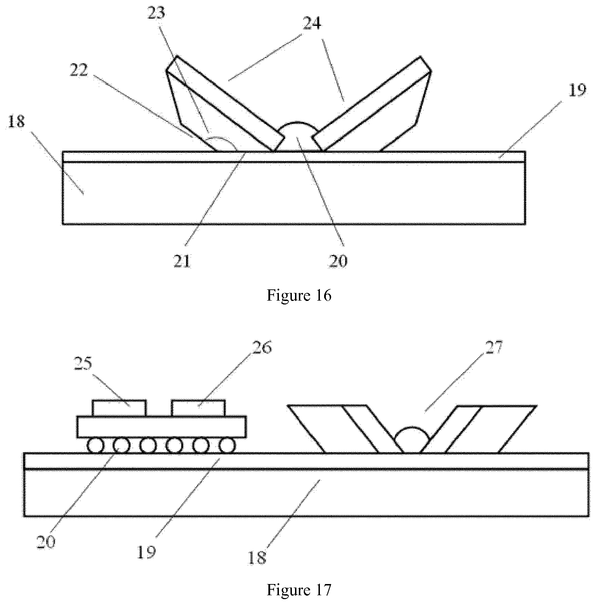

In order to form a triaxial bridge sensor as shown in Figure 17, a first MTJ packaging method includes the following steps: A) fabricating a X-axis bridge sensor 25 that has a sensing direction along a X-axis and is electrically connecting the X-axis sensor with ASIC chip 19; B) fabricating a Y-axis bridge sensor 26 that has a sensing direction along a Y-axis and is electrically connecting the Y-axis sensor with ASIC chip 19; C) fabricating MTJ magnetoresistive elements 1 on a wafer 18 as shown in Figure 9, cutting said MTJ wafer obliquely to form MTJ magnetic sensor chips 24 as shown in Figure 10; placing the attachment edge 21 of the MTJ magnetic sensor chips 24 onto the ASIC chip 19 as shown in Figure 11; Wherein each said attachment edge 21 is at an angle with respect to the adjacent surface 22 of the substrate, and the angle 23 is an acute angle or an obtuse angle; physically connecting each of the MTJ magnetic sensor chips 24 with the ASIC chip 19 using solder bumps 20 as shown in Figure 12; and electrically connecting the MTJ magnetic sensing elements 24 to form a Z-axis magnetic sensor 27.

The MTJ magnetic sensor chip 24 can be a bridge type magnetic field sensor chip can be fabricated in one step as shown in Figures 4 and 6, but it may also be comprised of magnetoresistive elements chips as shown in Figure 3 that are interconnected in order to form a magnetic sensor bridge.

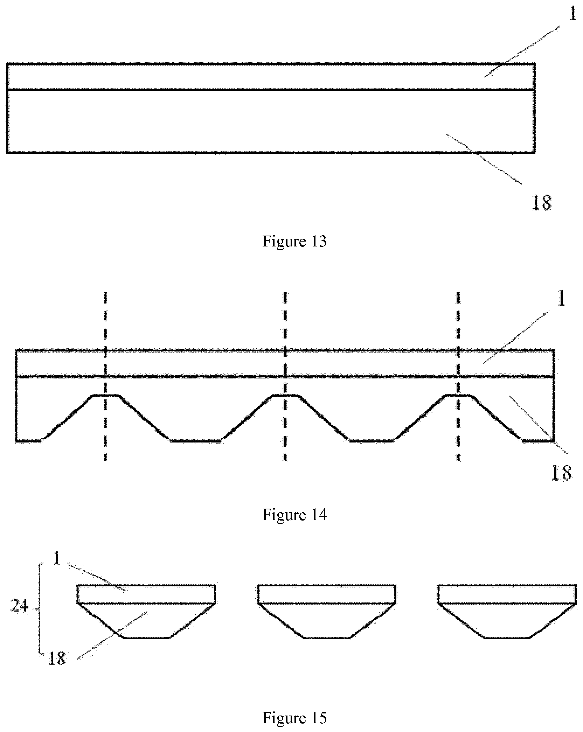

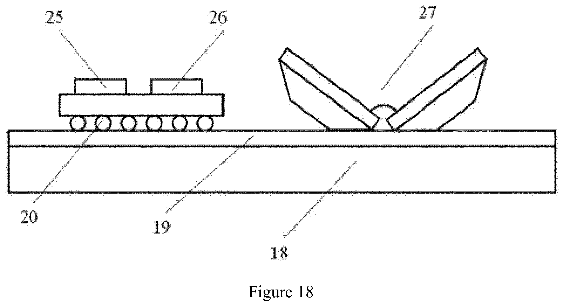

Figure 18 shows a second preparation method for building a triaxial MTJ magnetic field sensor, comprising the steps of A) fabricating a X-axis magnetic field sensor bridge 25 that has a sensing direction along a X-axis and electrically connecting the X-axis sensor to ASIC chip 19; B) fabricating a Y-axis magnetic field sensor bridge 26 that has a sensing direction along a Y-axis and electrically connecting the Y-axis sensor to ASIC chip 19; and C) fabricating MTJ magnetoresistive elements 24 on a wafer 18 as shown in Figure 13; preparing the backside of the wafer for connection to the ASIC chip 19 by etching the back side of said wafer to form slopes; cutting the MTJ wafer to form MTJ magnetic sensor chips 24 as shown in Figures 14 and 15; placing the attachment edge 21 of the MTJ magnetic sensor chips 24 onto the ASIC chip 19; each said attachment edge 21 is at an angle 23 with respect to the adjacent surface of the substrate 22, and the angle 23 is an acute angle or an obtuse angle; physically connecting each of the MTJ magnetic sensor chips 24 with the ASIC chip 19 using solder bumps 20 as shown in Figure 16; and electrically connecting the MTJ magnetic sensing elements 24 to form a Z-axis magnetic sensor 27.

The MTJ magnetic sensor chip 24 can be a bridge type magnetic field sensor chip as shown in Figures 4 and 6, but it may also be comprised of magnetoresistive elements chips as shown in Figure 3 that are interconnected in order to form a magnetic sensor bridge.

The above described embodiments demonstrate specific implementations of the present invention, and obviously other specific implementations exist within the scope of the appended claims. It will be apparent to those skilled in the art that various modifications can be made to the present invention without departing from the scope of the appended claims.

**Claims**

1. A triaxial MTJ sensor, comprising:

an X-axis bridge sensor (25) with a sensing direction along a X-axis,
a Y-axis bridge sensor (26) that has a sensing direction along a Y-axis,
a Z-axis sensor (27) that has a sensing direction along a Z-axis, and
an ASIC chip (19) for signal conditioning,

wherein the X-axis, the Y-axis, and the Z-axis are mutually orthogonal;
**characterized in that** the X-axis bridge sensor, the Y-axis bridge sensor, and the Z-axis sensor are connected onto a connection face of the ASIC chip;
wherein said Z-axis sensor comprises a plurality of electrically interconnected magnetic sensor chips (24), and each of the magnetic sensor chips is comprised of a substrate with a deposition face onto which a MTJ element is deposited and an attachment face that is acutely or obtusely angled with respect to the deposition face, and wherein an attachment face of each magnetic sensor chip is connected onto the connection face of the ASIC chip.

2. A triaxial MTJ sensor as in claim 1, wherein each of the Z-axis magnetic sensor chips (24) comprises a pair of parallel attachment faces.

3. A triaxial MTJ sensor as in claim 1, wherein each of the Z-axis magnetic sensor chips (24) comprises a pair of attachment faces (21) that are symmetrically arranged with respect to a plane perpendicular to the deposition face (22).

4. A triaxial MTJ sensor as in claim 1, wherein the Z-axis sensor (27) includes two or four MTJ magnetic sensor chips (24), and said MTJ sensor chips are symmetrically arranged on the ASIC chip (19).

5. A triaxial MTJ sensor as in claim 1, wherein the X-axis bridge sensor is a MTJ sensor.

6. A triaxial MTJ sensor as in claim 1, wherein the Y-axis bridge sensor is a MTJ sensor.

7. A triaxial MTJ sensor as in claim 1, wherein the X-axis bridge sensor and the Y-axis bridge sensor are connected with the ASIC chip using gold wire bonds.

8. A triaxial MTJ sensor as in claim 1, wherein the X-axis bridge sensor and the Y-axis bridge sensor are connected with the ASIC chip using solder bumps.

9. A triaxial MTJ sensor as in claim 1, wherein the X-axis bridge sensor and the Y-axis bridge sensor are integrated into the same chip.

10. A triaxial MTJ sensor as in claim 7, wherein the X-axis bridge sensor has two branches electrically connected in parallel that comprise a first pair of MTJ elements (R1 and R3) and a second pair of MTJ elements (R2 and R4) that are each separately electrically connected between the MTJ elements of the first pair (R1 and R3),
wherein the MTJ elements of the second pair (R2 and R4) have a lower magnetoresistive sensitivity than the MTJ elements of the first pair (R1 and R3), and
the Y-axis bridge sensor having two branches electrically connected in parallel that comprise a third pair of MTJ elements (R1 and R3) and a fourth pair of MTJ elements (R2 and R4) that are each separately electrically connected between the MTJ elements of the third pair (R1 and R3),
each MTJ element of the Y-axis bridge sensor has a pinned layer (2) with a common pinned layer magnetization direction (8) and a free layer (6) with a respective freelayer magnetization direction (7),
wherein in the absence of an magnetic field external to the triaxial MTJ sensor,
the freelayer magnetization directions (7) of each MTJ element of the third pair deviates from the pinned layer magnetization direction (8) by an angle ($\theta$), and
the freelayer magnetization directions (7) of each MTJ element of the fourth pair deviates from the pinned layer magnetization direction (8) by an angle of opposite sign and equal magnitude (θ) to the MTJ elements of the third pair.

**11.** A triaxial MTJ sensor as in claim 1, wherein each of the magnetic sensor chips is connected with the ASIC chip using solder bumps.

**12.** A triaxial MTJ sensor packaging method, comprising the steps of:

A) fabricating a X-axis bridge sensor that has a sensing direction along a X-axis and electrically connecting the X-axis sensor with an ASIC chip,

B) fabricating a Y-axis bridge sensor that has a sensing direction along a Y-axis and electrically connecting the Y-axis sensor with the ASIC chip, **characterized by**

C) fabricating MTJ magnetoresistive elements on the deposition face of a wafer, cutting said MTJ wafer obliquely to form MTJ magnetic sensor chips with attachment faces that are acutely or obtusely angled with respect to the deposition face; placing one of the attachment faces of each MTJ magnetic sensor chip onto the ASIC chip; physically connecting each of the MTJ magnetic sensor chips with the ASIC chip using solder bumps; and electrically connecting the MTJ magnetic sensing elements to form a Z-axis magnetic sensor.

**13.** A triaxial MTJ sensor packaging method, comprising the steps of:

A) fabricating a X-axis magnetic field sensor bridge that has a sensing direction along a X-axis and electrically connecting the X-axis sensor to an ASIC chip,

B) fabricating a Y-axis magnetic field sensor bridge that has a sensing direction along a Y-axis and electrically connecting the Y-axis sensor to the ASIC chip, **characterized by**

C) fabricating MTJ magnetoresistive elements on the deposition face of a wafer, etching the opposite side of said wafer to form slopes; cutting the wafer to form MTJ magnetic sensor chips with attachment faces that are acutely or obtusely angled with respect to the deposition face; placing one of the attachment faces of each MTJ magnetic sensor chip onto the ASIC chip; physically connecting each of the MTJ magnetic sensor chips with the ASIC chip using solder bumps; and electrically connecting the MTJ magnetic sensing elements to form a Z-axis magnetic sensor.

**Patentansprüche**

**1.** Dreiachsiger MTJ-Sensor, umfassend:

einen X-Achsen-Brückensensor (25) mit einer Erfassungsrichtung entlang einer X-Achse,
einen Y-Achsen-Brückensensor (26), der eine Erfassungsrichtung entlang einer Y-Achse aufweist,
einen Z-Achsen-Sensor (27), der eine Erfassungsrichtung entlang einer Z-Achse aufweist,
einen ASIC-Chip (19) für die Signalaufbereitung,
wobei die X-Achse, die Y-Achse und die Z-Achse orthogonal zueinander sind;
**dadurch gekennzeichnet, dass** der X-Achsen-Brückensensor, der Y-Achsen-Brückensensor und der Z-Achsen-Brückensensor mit einer Verbindungsfläche des ASIC-Chips verbunden sind;
wobei der Z-Achsen-Sensor eine Vielzahl von elektrisch miteinander verbundenen Magnetsensorchips (24) umfasst und jeder der Magnetsensorchips aus einem Substrat mit einer Ablagerungsfläche, auf die ein MTJ-Element abgelagert ist, und einer Befestigungsfläche, die spitz- oder stumpfwinklig bezüglich der Ablagerungsfläche ist, besteht, und wobei eine Befestigungsfläche jedes Magnetsensorchips auf der Verbindungsfläche des ASIC-Chips verbunden ist.

**2.** Dreiachsiger MTJ-Sensor nach Anspruch 1, wobei jeder des Z-Achsen-Magnetsensorchips (24) ein Paar paralleler Befestigungsflächen umfasst.

**3.** Dreiachsiger MTJ-Sensor nach Anspruch 1, wobei jeder der Z-Achsen-Magnetsensorchips (24) ein Paar Befestigungsflächen (21) umfasst, die symmetrisch bezüglich einer Ebene, die rechtwinklig zur Ablagerungsfläche (22) ist, angeordnet ist.

**4.** Dreiachsiger MTJ-Sensor nach Anspruch 1, wobei der Z-Achsen-Sensor (27) zwei oder vier MTJ-Magnetsensorchips (24) enthält und die MTJ-Sensorchips symmetrisch auf dem ASIC-Chip (19) angeordnet sind.

5. Dreiachsiger MTJ-Sensor nach Anspruch 1, wobei der X-Achsen-Brückensensor ein MTJ-Sensor ist.

6. Dreiachsiger MTJ-Sensor nach Anspruch 1, wobei der Y-Achsen-Brückensensor ein MTJ-Sensor ist.

7. Dreiachsiger MTJ-Sensor nach Anspruch 1, wobei der X-Achsen-Brückensensor und der Y-Achsen-Brückensensor mit dem ASIC-Chip mithilfe von Golddrahtverbindungen verbunden sind.

8. Dreiachsiger MTJ-Sensor nach Anspruch 1, wobei der X-Achsen-Brückensensor und der Y-Achsen-Brückensensor mit dem ASIC-Chip mithilfe von Löthöckern verbunden sind.

9. Dreiachsiger MTJ-Sensor nach Anspruch 1, wobei der X-Achsen-Brückensensor und der Y-Achsen-Brückensensor in denselben Chip integriert sind.

10. Dreiachsiger MTJ-Sensor nach Anspruch 7, wobei der X-Achsen-Brückensensor zwei Zweige aufweist, die elektrisch parallel verbunden sind, die ein erstes Paar MTJ-Elemente (R1 und R3) und ein zweites Paar MTJ-Elemente (R2 und R4) umfassen, die jeweils separat elektrisch zwischen den MTJ-Elementen des ersten Paars (R1 und R3) verbunden sind,
wobei die MTJ-Elemente des zweiten Paars (R2 und R4) eine niedrigere magnetoresitive Empfindlichkeit aufweisen als die MTJ-Elemente des ersten Paars (R1 und R3) und
der Y-Achsen-Brückensensor zwei Zweige aufweist, die elektrisch parallel verbunden sind, die ein drittes Paar MTJ-Elemente (R1 und R3) und ein viertes Paar MTJ-Elemente (R2 und R4) umfassen, die jeweils separat elektrisch zwischen den MTJ-Elementen des dritten Paars (R1 und R3) verbunden sind,
jedes MTJ-Element des Y-Achsen-Brückensensors eine Pinning-Schicht (2) mit einer gemeinsamen Pinning-Schicht-Magnetisierungsrichtung (8) und eine freie Schicht (6) mit einer jeweiligen Freie-Schicht-Magnetisierungsrichtung (7) aufweist,
wobei in Abwesenheit eines Magnetfelds, das extern zum dreiachsigen MTJ-Sensor ist,
die Freie-Schicht-Magnetisierungsrichtungen (7) jedes MTJ-Elements des dritten Paars von der Pinning-Schicht-Magnetisierungsrichtung (8) um einen Winkel ($\theta$) abweichen, und
die Freie-Schicht-Magnetisierungsrichtungen (7) jedes MTJ-Elements des vierten Paars von der Pinning-Schicht-Magnetisierungsrichtung (8) um einen Winkel mit umgekehrtem Vorzeichen und gleicher Größe ($\theta$) von den MTJ-Elementen des dritten Paars abweichen.

11. Dreiachsiger MTJ-Sensor nach Anspruch 1, wobei jeder der Magnetsensorchips mit dem ASIC-Chip mithilfe von Löthöckern verbunden ist.

12. Dreiachsiger MTJ-Sensor-Verpackungsverfahren, umfassend die folgenden Schritte:

A) ein Herstellen eines X-Achsen-Brückensensors, der eine Erfassungsrichtung entlang einer X-Achse aufweist und den X-Achsen-Sensor elektrisch mit einem ASIC-Chip verbindet,
B) ein Herstellen eines Y-Achsen-Brückensensors, der eine Erfassungsrichtung entlang einer Y-Achse aufweist und den Y-Achsen-Sensor elektrisch mit dem ASIC-Chip verbindet, **gekennzeichnet durch**
C) ein Herstellen MTJ-magnetoresistiver Elemente auf der Ablagerungsfläche eines Wafers, ein schräges Schneiden des MTJ-Wafers, um einen MTJ-Magnetsensorchip mit Befestigungsflächen zu formen, die spitz- oder stumpfwinklig bezüglich der Ablagerungsfläche sind; ein Platzieren einer der Befestigungsflächen jedes MTJ-Magnetsensorchips auf den ASIC-Chip; ein physikalisches Verbinden jedes der MTJ-Magnetsensorchips mit dem ASIC-Chip mithilfe von Löthöckern; und ein elektrisches Verbinden der MTJ-Magnetsensorelemente, um einen Z-Achsen-Magnetsensor zu formen.

13. Dreiachsiger MTJ-Sensor-Verpackungsverfahren, umfassend die folgenden Schritte:

A) ein Herstellen einer X-Achsen-Magnetfeldsensorbrücke, die eine Erfassungsrichtung entlang einer X-Achse aufweist und den X-Achsen-Sensor elektrisch mit einem ASIC-Chip verbindet,
B) ein Herstellen einer Y-Achsen-Magnetfeldsensorbrücke, die eine Erfassungsrichtung entlang einer Y-Achse aufweist und den Y-Achsen-Sensor elektrisch mit dem ASIC-Chip verbindet, **gekennzeichnet durch**
C) ein Herstellen MTJ-magnetoresistiver Elemente auf der Ablagerungsfläche eines Wafers, ein Ätzen der gegenüberliegenden Seite des Wafers, um Neigungen zu formen; ein Schneiden des MTJ-Wafers, um einen MTJ-Magnetsensorchip mit Befestigungsflächen zu formen, die spitz- oder stumpfwinklig bezüglich der Ablagerungsfläche sind; ein Platzieren einer der Befestigungsflächen jedes MTJ-Magnetsensorchips auf den ASIC-Chip; ein physikalisches Verbinden jedes der MTJ-Magnetsensorchips mit dem ASIC-Chip mithilfe von Löthöckern; und ein elektrisches Verbinden der MTJ-Magnetsensorelemente, um einen Z-Achsen-Magnetsensor zu formen.

**Revendications**

1. Capteur à jonction tunnel magnétique (MTJ) triaxial, comprenant :

   un capteur en pont d'axe X (25) avec une direction de détection le long d'un axe X,
   un capteur en pont d'axe Y (26) qui possède une direction de détection le long d'un axe Y,
   un capteur d'axe Z (27) qui possède une direction de détection le long d'un axe Z, et
   une puce ASIC (19) pour le conditionnement de signal,
   ledit axe X, ledit axe Y et ledit axe Z étant mutuellement orthogonaux ;
   **caractérisé en ce que** le capteur en pont d'axe X, le capteur en pont d'axe Y et ledit capteur d'axe Z sont connectés sur une face de connexion de la puce ASIC ;
   ledit capteur d'axe Z comprenant une pluralité de puces de capteur magnétique interconnectées électriquement (24), et chacune des puces de capteur magnétique comprenant un substrat avec une face de dépôt sur laquelle un élément MTJ est déposé et une face de fixation qui est anguleusement aiguë ou obtuse par rapport à la face de dépôt, et une face de fixation de chaque puce de capteur magnétique étant connectée sur la face de connexion de la puce ASIC.

2. Capteur MTJ triaxial selon la revendication 1, chacune des puces de capteur magnétique d'axe Z (24) comprenant une paire de faces de fixation parallèles.

3. Capteur MTJ triaxial selon la revendication 1, chacune des puces de capteur magnétique à axe Z (24) comprenant une paire de faces de fixation (21) qui sont agencées symétriquement par rapport à un plan perpendiculaire à la face de dépôt (22).

4. Capteur MTJ triaxial selon la revendication 1, ledit capteur d'axe Z (27) comprenant deux ou quatre puces de capteur magnétique MTJ (24), et lesdites puces de capteur MTJ étant disposées symétriquement sur la puce ASIC (19).

5. Capteur MTJ triaxial selon la revendication 1, ledit capteur en pont d'axe X étant un capteur MTJ.

6. Capteur MTJ triaxial selon la revendication 1, ledit capteur en pont d'axe Y étant un capteur MTJ.

7. Capteur MTJ triaxial selon la revendication 1, ledit capteur en pont d'axe X et ledit capteur en pont d'axe Y étant connectés à la puce ASIC à l'aide de liaisons filaires en or.

8. Capteur MTJ triaxial selon la revendication 1, ledit capteur en pont d'axe X et ledit capteur en pont d'axe Y étant connectés à la puce ASIC à l'aide des bosses de soudure.

9. Capteur MTJ triaxial selon la revendication 1, ledit capteur de pont d'axe X et ledit capteur de pont d'axe Y étant intégrés dans la même puce.

10. Capteur MTJ triaxial selon la revendication 7, ledit capteur en pont d'axe X possédant deux branches connectées électriquement en parallèle qui comprennent une première paire d'éléments MTJ (R1 et R3) et une deuxième paire d'éléments MTJ (R2 et R4) qui sont connectés électriquement de manière séparée entre les éléments MTJ de la première paire (R1 et R3),
    lesdits éléments MTJ de la deuxième paire (R2 et R4) possédant une sensibilité magnétorésistive inférieure à celle des éléments MTJ de la première paire (R1 et R3), et
    ledit capteur en pont d'axe Y possédant deux branches connectées électriquement en parallèle qui comprennent une troisième paire d'éléments MTJ (R1 et R3) et une quatrième paire d'éléments MTJ (R2 et R4) qui sont chacune connectées électriquement de manière séparée entre les éléments MTJ de la troisième paire (R1 et R3),
    chaque élément MTJ du capteur de pont d'axe Y possédant une couche fixée (2) avec une direction d'aimantation de couche fixée commune (8) et une couche libre (6) avec une direction d'aimantation de couche libre respective (7), en l'absence d'un champ magnétique extérieur au capteur MTJ triaxial,
    lesdites directions de magnétisation de couche libre (7) de chaque élément MTJ de la troisième paire s'écartant de

11

la direction de magnétisation de couche fixée (8) d'un angle (θ), et

lesdites directions de magnétisation de couche libre (7) de chaque élément MTJ de la quatrième paire s'écartant de la direction de magnétisation de couche fixée (8) d'un angle de signe opposé et d'amplitude égale (θ) aux éléments MTJ de la troisième paire.

11. Capteur MTJ triaxial selon la revendication 1, chacune des puces de capteur magnétique étant connectée à la puce ASIC à l'aide de bosses de soudure.

12. Procédé de conditionnement de capteur MTJ triaxial, comprenant les étapes de :

A) fabrication d'un capteur en pont d'axe X qui possède une direction de détection le long d'un axe X et connexion électrique du capteur d'axe X à une puce ASIC,

B) fabrication d'un capteur en pont d'axe Y qui possède une direction de détection le long d'un axe Y et connexion électrique du capteur d'axe Y à la puce ASIC, **caractérisé par**

C) la fabrication des éléments magnétorésistifs MTJ sur la face de dépôt d'une plaquette, le découpage de la plaquette MTJ de manière oblique pour former des puces de capteur magnétique MTJ avec des faces de fixation qui sont anguleusement aiguës ou obtuses par rapport à la face de dépôt ; la mise en place de l'une des faces de fixation de chaque puce de capteur magnétique MTJ sur la puce ASIC ; la connexion physique de chacune des puces de capteur magnétique MTJ à la puce ASIC à l'aide de bosses de soudure ; et la connexion électrique des éléments de détection magnétique MTJ pour former un capteur magnétique d'axe Z.

13. Procédé de conditionnement de capteur MTJ triaxial, comprenant les étapes de :

A) fabrication d'un pont de capteur de champ magnétique d'axe X qui possède une direction de détection le long d'un axe X et connexion électrique du capteur d'axe X à une puce ASIC,

B) fabrication d'un pont de capteur de champ magnétique d'axe Y qui possède une direction de détection le long d'un axe Y et connexion électrique du capteur d'axe Y à la puce ASIC, **caractérisé par**

C) fabrication des éléments magnétorésistifs MTJ sur la face de dépôt d'une plaquette, gravure du côté opposé de ladite plaquette pour former des pentes ; découpage de la plaquette pour former des puces de capteur magnétique MTJ avec des faces de fixation qui sont anguleusement aiguës ou obtuses par rapport à la face de dépôt ; mise en place de l'une des faces de fixation de chaque puce de capteur magnétique MTJ sur la puce ASIC ; connexion physique de chacune des puces de capteur magnétique MTJ à la puce ASIC à l'aide des bosses de soudure ; et connexion électrique des éléments de détection magnétique MTJ pour former un capteur magnétique d'axe Z.

Figure 1

Figure 2

Figure 3

Figure 4

Figure 5

Figure 6

Figure 7

EP 2 752 675 B1

Figure 8

Figure 9

Figure 10

Figure 11

Figure 12

Figure 13

Figure 14

Figure 15

Figure 16

Figure 17

Figure 18